# EUROPEAN PATENT APPLICATION

(11) **EP 4 386 821 A1**
(43) Date of publication of application: **19.06.2024**
(21) Application number: 22212690.6
(22) Date of filing: 12.12.2022
(51) Int. Cl.: H01L 21/67, H01L 21/683

(54) **METHOD OF HEATING SEMICONDUCTOR STRUCTURE**

(71) Applicant: Comptek Solutions OY, 20520 Turku (FI)
(72) Inventor: Mäkelä, Jaakko, Turku (FI); Lång, Jouko, Lieto (FI); Calvo Alonso, Vicente, Piispanristi (FI)
(74) Representative: Moosedog Oy

(57) **Abstract**

Disclosed is a method (100) and a system (200) for heating a semiconductor structure (202) for utilization in semiconductor manufacturing processes. The system (200) comprising an enclosure (204), a pump (206) configured to generate vacuum condition inside the enclosure (204), a laser heating source (208) mounted in the enclosure (204) to provide heat beam and a fixture (210) adapted to mount the given structure (202) thereon in the enclosure (204), wherein the fixture (210) is configured to be manipulated to expose the first surface (202A) of the semiconductor structure (202) to the heat beam from the laser heating source (208), by disposing the first surface (202A) opposing the laser heating source.

## Description

### TECHNICAL FIELD

The present disclosure relates to surface processing of semiconductor devices and more specifically to a method of heating a semiconductor structure surface for utilization in semiconductor manufacturing processes.

### BACKGROUND

Surface processing of semiconductor materials or devices usually implies the need for heating up the semiconductor materials so that they reach certain temperature at which a particular process needs to be implemented. Such processing includes, among others, plasma cleaning, thin film depositions, coating, etc.

Conventionally, the existing heating solutions use radiating sources that impose a high thermal load on the semiconductor structure to be treated, such as semiconductor substrates, and consequently heat the entire semiconductor structure. Such conventional heating solutions require the heating to be done from an opposite side (or end) with respect to the surface of the semiconductor structure being treated (or heated). As a result, the heating sources become highly power consuming elements, due to the requirement to apply thermal energy to a surface/facet opposing the surface/facet to be treated, thereby leaving the treated surface/facet "free" (or largely unaffected), thus requiring a higher thermal load to compensate for the indirect approach. However, such higher thermal loads imposed on the structures may lead to strain relaxation or internal substrate structural degradation, damaged surface layers such as contacts, or other metallic layers present in the semiconductor chips, during processing, such as, during passivation processes that usually take place at later stages of the semiconductor manufacturing process, and when metallic layers are already present. A particular example of these problems is present during cleaning and passivation of laser facets of edge emitting lasers.

Semiconductor lasers (or diode lasers) are electro-optical devices operable to convert electrical energy into light, for implementation in a plethora of applications such as, but not limited to, telecommunication systems, optical communication systems, monitoring systems, tissue processing, printers, optical storage drives, and the like. Herein, and particularly for lasers based upon III-V compound semiconductors, a dominant root cause of failure for high power semiconductor lasers is known as Catastrophic Optical Mirror Damage (COMD), a phenomenon which impairs the maximum output of a high-power edge-emitting laser chip. In some examples, passivation of the laser facets is implemented to prevent the aforementioned problems. However, such solutions additionally require a semiconductor heating process to maintain the surface/facet, to be passivated, at a certain required temperature.

Additionally, to treat (passivate or heat) both surfaces/facets of the semiconductor structure, conventional processes require each surface/facet to be treated independently and thereby making the system highly complex and time consuming.

Therefore, in light of the foregoing discussion, there exists a need to overcome the aforementioned drawbacks associated with existing treatment techniques and provide an improved method of heating a cleaved semiconductor structure for utilization in semiconductor manufacturing processes.

### SUMMARY

The present disclosure seeks to provide a method of heating a semiconductor structure for utilization in semiconductor surface processes. Surface processing of semiconductor structures, materials, or devices, usually implies the need for heating up them so that they reach certain temperature at which a particular process needs to be implemented. Such processing includes, among others, plasma cleaning, thin film depositions, coating, etc. The present disclosure also seeks to provide a system for heating a semiconductor structure surface for utilization in semiconductor manufacturing processes. An aim of the present disclosure is to provide a solution that overcomes at least partially the problems encountered in prior art.

In one aspect, an embodiment of the present disclosure provides a method of heating a semiconductor structure surface for utilization in semiconductor manufacturing processes, the method comprising:
- providing an enclosure comprising a fixture to mount the given semiconductor structure thereon, which enclosure is adapted to provide vacuum condition inside thereof;
- providing heat beam by a laser heating source, and focusing the heat beam from the laser source inside the enclosure, and
- exposing a first surface of the semiconductor structure in the enclosure to heat beam from the laser heating source opposing the first surface by manipulating the fixture therein, to heat the first surface of the semiconductor structure.

In another aspect, an embodiment of the present disclosure provides a system for heating a semiconductor structure surface for utilization in semiconductor manufacturing processes, the system comprising:
- an enclosure;
- a pump configured to generate vacuum condition inside the enclosure;
- a laser heating source to provide heat beam,
- an optical device configured to define the distribution or phase of the irradiated heat beam from the laser heating; and
- a fixture adapted to mount the given structure thereon in the enclosure, wherein the fixture is configured to be manipulated to expose a first surface of the semiconductor structure to the heat beam from the laser heating source, by disposing the first surface opposing the laser heating source.

Embodiments of the present disclosure substantially eliminate or at least partially address the aforementioned problems in the prior art and provide an improved a method of heating a semiconductor structure for utilization in semiconductor manufacturing processes.

### BRIEF DESCRIPTION OF THE DRAWINGS

Embodiments of the present disclosure will now be described, by way of example only, with reference to the following diagrams wherein:
- FIG. 1: is a flowchart listing steps involved in a method of heating a semiconductor structure for utilization in semiconductor manufacturing processes;
- FIG. 2A: is a representative diagram of an exemplary semiconductor bar comprising multiple semiconductor structures therein;
- FIG. 2B: is a representative diagram of one of the semiconductor structure of the semiconductor bar of FIG. 2A;
- FIG. 2C: is a block diagram of a system for heating a semiconductor structure for utilization in semiconductor manufacturing processes;
- FIG. 3A: is a representative diagram of exemplary semiconductor structure before cleaning a first surface thereof;
- FIG. 3B: is a representative diagram of exemplary semiconductor structure after cleaning the first surface thereof;
- FIG. 3C: is a representative diagram of exemplary semiconductor structure with the first surface thereof passivated with an ordered oxide layer;
- FIG. 4A: is a schematic diagram of an exemplary stacking fixture for an enclosure of the system;
- FIG. 4B: is a detailed view of an exemplary fixture holding the plurality of semiconductor structures;
- FIG. 5A: is a schematic diagram of a conventional heating method for heating the semiconductor structure;
- FIG. 5B: is a schematic diagram of a frontal heating-mechanism of the method of FIG. 1 or system of FIG. 2C for heating the semiconductor structure to be utilized in semiconductor manufacturing processes;
- FIG. 5C: is a schematic diagram of a dual heating-mechanism of the method of FIG. 1 or system of FIG. 2C for heating the semiconductor structure to be utilized in semiconductor manufacturing processes;
- FIG. 6: is a graphical representation of temperature variations inside the semiconductor structure;
- FIG. 7: is a representation of the different absorption wavelengths of different semiconductors; and
- FIG. 8: is a representation of the different absorption wavelengths of AlGaAs with different aluminium content.

### DETAILED DESCRIPTION OF EMBODIMENTS

The present disclosure provides a method of heating the surface of semiconductor structure for utilization in semiconductor manufacturing processes, and/or systems. The term *"heating"* refers to the process of application of thermal energy to the semiconductor structure to treat the semiconductor device and thereby enable utilization in surface related semiconductor manufacturing processes such as, but not limited to, passivation, cleaning, exposure, development, coating, treatment, deposition, and the like. For example, the heating of the semiconductor structure is required to enable passivation of the semiconductor structure formed with surface oxidation processes, or with deposition of an oxide layer and/or a nitride layer onto the semiconductor structure such as, for utilization as a laser device.

The method of the present disclosure is aimed to reduce the limitations of temperature existing in conventional processes and/or systems, via a novel frontal heating mechanism utilizing a desired laser device that targets to heat up only the surface of the semiconductor substrate. In a method of the present disclosure, the entire surface of the semiconductor structure is heated up with a laser beam of a laser heating source with a uniform power, and further, without using the laser beam of the laser heating source in a laser scanning mode. The heat beam is designed to be directed over the entire surface area of the semiconductor structure. As a result, laser scanning mode is not needed in the present method.

Herein, the method is configured to enable selection of wavelength(s) of the heating laser(s) such that the heat radiation is efficiently absorbed by the surface of the structure being heated and quickly dissipated. The method is configured to provide localized heating of the structure to effectively treat only the exposed surfaces and prevent damages thereof. Moreover, beneficially, the method of present disclosure provides for simultaneous heating and/or treatment of both facets/surfaces of the semiconductor structure, wherein the heating process comprises rapid heating and cooling periods, further increasing the processing speed, and thereby improving the manufacturing output and operational efficiency and associated operational costs and time. Additionally, beneficially, the method of the present disclosure enables to treat two opposed facets/surfaces of a semiconductor structure at the same time. For example, in cleaved semiconductor structures, such as laser bars, both facets may need to be treated. This method enables both facets of the semiconductor structure to be treated at the same time and within a single chamber. There can be two different heating laser systems within a single vacuum chamber: one heating source for each facet/surface, and corresponding two cleaning sources, are present for treatment of each facet/surface of the cleaved semiconductor structure. Correspondingly, other semiconductor manufacturing processes, such as, the passivation process, deposition process, are enabled to be performed on both facets/surfaces of the semiconductor structure simultaneously. Although the semiconductor structure referred to herein, and in connection with the present disclosure, may be cleaved, the semiconductor structures referred to herein are not limited to cleaved semiconductor structures.

As used throughout the present disclosure, the term *"semiconductor structure"* refers to a layer or block of a material upon or within which elements of a semiconductor device are fabricated or attached. For example, the semiconductor structure may be formed using at least one of silicon (Si), gallium (Ga), germanium (Ge), arsenic (As) and elements such as, nitrogen (N), carbon (C) and so forth or a combination of two or more of these materials such as, but not limited to, silicon carbide (SiC), gallium nitride (GaN), gallium arsenide (GaAs) or sapphire. In present examples, the semiconductor structure may be GaAs or Indium phosphide (InP), based structure which is suitable for forming the edge-emitting laser device, and other HEMT, MESFET, or other optoelectronic structures. Optionally, an edge-emitting laser device is fabricated using the cleaved semiconductor structure by implementing the method of the present disclosure, and thereby achieves all features and advantages of the present disclosure.

The method comprises providing an enclosure having a fixture to mount the given structure thereon in the enclosure and adapted to provide vacuum condition inside thereof. The *"enclosure"* refers to an external body that may comprise a single-chamber system for inertly storing a given semiconductor structure and preventing exposure from the surroundings. For example, the enclosure is a vacuum chamber configured to provide ultra-high-vacuum level between 10⁻⁷ and 10⁻¹² mbar, high-vacuum level between 10⁻⁷ and 10⁻³ mbar, medium vacuum level between 10⁻³ and 1 mbar, and/or a vacuum ranging between atmospheric pressure and 1 mbar. Optionally, the enclosure may comprise a chamber, wherein the given semiconductor structure may be loaded or transferred. Further, the enclosure comprises the fixture configured to mount the given structure (upon being loaded) to the enclosure. The term *"fixture"* refers to a customized support device configured to securely locate, support, and mount the semiconductor structure leaving the facets/surfaces to be treated freely exposed and enable external manipulation thereof. In an example, the fixture may be a type of jig (such as, a stacking jig, a plate jig, channel jigs, etc.). In another example, the fixture may be a metallic frame configured to mount multiple cleaved semiconductor structures. Moreover, it will be appreciated that the fixture may be mounted, with other fixtures having stacked semiconductor structures thereat, and thereby treated in conjunction as per the present method. Beneficially, such an arrangement, of the semiconductor structures, improves the efficiency of the present method by enabling mass production owing to the higher number of semiconductor structures that may be processed parallelly at a single time via the method. In the case of processing semiconductor cleaved structures, such as laser bars, multiple such semiconductor bars may preferably be stacked in the fixture for simultaneous processing, allowing for bulk production and high throughput. Optionally, the cleaved semiconductor structures are mounted on the fixture (such as, a stacking jig), such that the first facets of the multiple cleaved semiconductor structures are aligned in the same direction, and the treatment steps of the method affect each of the facets in a similar manner.

The method further comprises exposing a first surface of the semiconductor structure in the enclosure to heat beam from the laser heating source opposing the first surface by manipulating the fixture therein, to heat the first surface of the semiconductor structure. Herein, the entire fixture may be manipulated or repositioned to accommodate (or directly face) the incoming heat beam from the laser heating source uniformly. Beneficially, the maximum amount of heat beam is received by the exposed first surface of the semiconductor structure due to the manipulation and thereby, the first surface is heated up efficiently to the desired processing temperature. Further, the heat beam may also clean the first surface from contaminants efficiently and accurately due to the higher precision control and increased energy efficiency of the heat beam provided by the laser heating source.

Herein, the term *"heat beam"* refers to the irradiated beam from the laser heating source configured to provide heat energy towards a desired location to heat or clean the surface (or facets) of the semiconductor structure of any possible contaminants (such as, moisture). In an example, the method may employ micro pulse lasers or high-power lasers, i.e., short pulse laser having high power, that are able to heat without damaging the surfaces of the semiconductor structures, for heating the first surface of the semiconductor structure. Herein, since the power input (or peak power) to the high-power short pulse laser is extremely high for a shorter duration, the heat-affected zone (HAZ) is lower than other types of lasers and the heating process takes lesser time in comparison to other types of lasers. Furthermore, properly selected laser beam characteristics will also improve the cooling down or heat dissipation through the substrate, to prevent the heat up mechanism that will otherwise damage the semiconductor structure. In still other examples, the method may employ continuous wavelength lasers, or pulse lasers of different wavelengths or powers based on the implementation. It will be appreciated that the method may vary the essential laser parameters such as laser intensity, wavelength, pulse duration, pulse width, and incident angle to potentially improve the heating effect on the surface and at the same time promote the efficient heat dissipation through the sample and may employ any laser heating source and corresponding heat beam techniques based on the needs of the implementation. In present examples, the laser heating source may be a type of solid-state lasers, gas lasers, and so forth.

In a method of the present disclosure, the heat power densities used for laser heating may be typically in the range of 0.2-20 W/cm². For example, in the range of 1-10 W/cm², wherein a higher power density means a higher temperature. The shorter and higher intensity of the pulse, the more it will have heating effect localized to the surface. In excimer lasers, a pulse width in the range of ~ns may be used to decompose the surface oxides. To achieve a sufficient heating effect, the width of the pulse used can be, for example, in the range 10-100 µs, for rise/fall times ~20 µs, and the width of the period can be, for example, in the range 100-400 µs. The highest power and shortest pulse width are expected to give the best result.

In some examples, the laser heating source may be configured to direct the heat beam towards a first surface/facet of the semiconductor structure to heat the first surface/facet for cleaning and/or removing any potentially present contaminants before further treatment. For example, the heating may remove any moisture, gases, and other contaminants on the cleaned first facet (surface). Notably, the temperature measured in the enclosure during heating may remain constant (for example, room temperature) during operation in contrast to existing systems and processes due to the localized heating effect of the heat beam provided by the laser heating source. That is, the heat beam may be localized only to the exposed first surface/facet of the semiconductor structure. Beneficially, via such an application of the laser heating source, the thermal load applied to the whole semiconductor structure is lower in comparison to prior art, wherein the heating was conducted from the non-exposed surface/facet and thereby prevents the corresponding high risk of damage due to exposure to high temperatures through the whole structure.

The temperature measured in the enclosure during heating remains substantially constant (for example, room temperature) during heating, wherein the exposure to the laser radiation is localized to the exposed first surface/facet and may be varied for different periods of time. For example, the first facet of the cleaved semiconductor structure may be heated for 1 minute, 5 minutes, 10 minutes, 15 minutes, 20 minutes, 30 minutes, 60 minutes and so forth. It will be appreciated by a person skilled in the art that the pressure, temperature, and exposure duration may be varied based on the implementation without limiting the scope of the present disclosure.

In one or more embodiments, the method further comprises providing a beam shaper to shape the heat beam from the laser heating source to be directed to a first surface of the semiconductor structure. The term *"beam shaper"* as used herein refers to an optical device or arrangement configured to define the distribution or phase of the irradiated heat beam from the laser heating source. For example, the beam shaper may be at least one of a refractive beam shaper, a diffractive beam shaper, a collimating lens unit, a chromatic lens unit, a refractive beam shaper, anamorphic prism unit, or a laser beam integrator. Herein, the beam shaper may be configured to define the heat beam shape i.e., defined via the irradiance distribution and phase thereof that enables the method to provide a uniform beam profile over a propagation distance (i.e., till the first surface of the semiconductor structure). Alternatively stated, the beam shaper is configured to redistribute the irradiance and phase of the heat beam to attain a desired beam profile that is maintained along the desired propagation distance. During heating the semiconductor structures, the heating area can be made very small, that is heating only the exposed surface of the semiconductor structure. For example, the heating beam may be shaped according to the geometry of the exposed surface of the semiconductor structure so that only the semiconductor structure is heated up. In present examples, the heating (laser) beam may be made rectangular, or may be made variable using beam shapers, so that the heating area is defined and localized. There can be a beam shaper for each of the laser heating sources. In some examples, the method may be configured to provide a heat beam having irradiance distributions that include Gaussian distributions, wherein irradiance decreases with increasing radial distance, and flat top beams, wherein irradiance is constant over a given area.

In one or more embodiments, the method further comprises providing the heat beam from the laser heating source with selective wavelength(s) based on the first surface of the semiconductor structure. Typically, the method may be configured to provide the heat beam with the selective wavelength(s), wherein the selective wavelength(s) are based on the first surface of the semiconductor structure. That is, the wavelength of the heat beam from the heating source is suitably varied to effectively heat only the exposed first surface of the semiconductor structure and preventing any potential damage thereof. In some examples, wavelength(s) of the heating beam may be suitably selected so that it may favourably heat up only surface of the semiconductor structure. By employing such heating technique, beneficially other components are not heated, and the enclosure is therefore operating at low temperatures. In conventional methods, typically very large heating elements are employed, involving heating the structures by radiation which may heat up other parts as well, and not only the target semiconductor structures and resulting in problems during further processing or treatment. Moreover, optionally, the power input of the laser heating source may also be suitably varied along with the wavelength of the heat beam to efficiently perform the heating operation in a localized manner.

In present examples, the laser heating source may be a type of solid-state lasers (such as, neodymium-doped yttrium aluminium garnet (Nd: YAG)) laser, or gas lasers (such as, carbon di-oxide laser, nitrogen laser), and so forth. The laser heating source directs the heat beam towards the first surface/facet of the semiconductor structure to heat the first surface/facet for either achieving the desired processing temperature in the semiconductor structure, or for cleaning and/or removing any potentially present contaminants before further treatment. For example, the heating may remove any moisture, gases, and other contaminants (e.g., adsorbed particles, N₂, CO₂, or O₂, among other contaminants) that have physically adsorbed to the surface of the semiconductor structure subsequent to cleaving. Optionally, the heat beam is provided by laser irradiation. Beneficially, the laser radiation provides high accuracy and precision control of the heat beam output and results in minimal or distortion and/or stress to the heated surface during operation.

In one or more embodiments, the laser heating source is mounted externally to the enclosure. There is further provided a transparent viewport to allow the heat beam from the laser heating source to reach the semiconductor structure. The term *"viewport"* refers to an access port configured to allow the heat beam from the heating source to reach the exposed first surface/facet of the semiconductor structure, i.e., after, or during, any manufacturing process such as cleaning, coating, and/or oxidation process of the first surface etc. It will be appreciated that based on the needs of the implementation, the location of the laser heating source and/or the beam shaper may be varied. They may be mounted externally or internally to the enclosure, for example, to reduce the physical footprint of the implementation. In the present examples, the laser heating source and/or the beam shaper may be located inside the enclosure while externally mounted to the first and/or enclosures, or outside the enclosure altogether, and accessible through an entry or access port i.e., the transparent viewport.

In one or more embodiments, a plurality of semiconductor structures is loaded in the enclosure, being stacked on top of each other at respective side facets/surfaces thereof, with the first surface being orthogonal to the corresponding surface in the respective semiconductor structure. The method further comprises manipulating the fixture in the enclosure to expose the first surface/facet of each of the semiconductor structure of the plurality of semiconductor structures to one or more of the heat beams from the laser heating source. That is, in embodiments wherein the plurality of semiconductor structures is loaded in the enclosure, each of the subsequent (apart from the first structure in each stack) semiconductor structures are stacked on top of each other at the respective side surfaces thereof. Herein, the fixture is configured to securely locate, support, and mount the plurality of semiconductor structures and enable external manipulation thereof. Moreover, it will be appreciated that the fixture may be mounted, with other fixtures having stacked semiconductor structures thereat, and thereby treated in conjunction via the method. Beneficially, such an arrangement of the semiconductor structures improves the efficiency of the method, by enabling mass production, owing to the higher number of semiconductor structures that may be processed parallelly at a single time via the method. In some embodiments, the semiconductor structures are mounted on a stacking fixture (such as, a stacking jig) on top of each other and provided to the enclosure i.e., repositioning and/or reorienting the fixture containing the semiconductor structures to expose the first surfaces of each semiconductor structure to one or more of the heat beams from the laser heating source.

In one or more embodiments, the semiconductor structure defines a second surface therein. The method further comprises manipulating the fixture in the enclosure to expose the second surface of the semiconductor structure to one or more of the heat beams from the laser heating source, without removing the semiconductor structure from the enclosure. It is preferable, in some semiconductor manufacturing processes, to form the passivation layer on both opposing surfaces of the semiconductor structure i.e., the first facet and the second facet, to prevent contaminants and amorphous oxide layer formation thereat. Herein, to form the passivation layer on the second facet, the orientation of the semiconductor structure within the enclosure is modified by manipulating the fixture such that the second facet may be exposed to one or more of the cleaning beams from the cleaning source, the heat beam from the laser heating source and the oxidation agent from the oxidizing source in. In contrast to conventional techniques, the reconfiguration of the fixture allows the second facet to be exposed to the said process(es) without the need to remove the semiconductor structure from the enclosure. Optionally, the method further comprises manipulating the fixture to expose the second facets of the stacked semiconductor structures, wherein manipulating the fixture involves reorienting or repositioning the fixture, comprising the mounted semiconductor structures, from a first orientation to a second different orientation within the enclosure such that the second facet are exposed to further treatment. Beneficially, the passivation of both the facets of the semiconductor structure provides greater level of protection and thus effectively prevent contaminants from depositing on the cleaned facets and prevents the re-formation of the amorphous oxide layers. Additionally, passivating both the facets of the semiconductor structure improves the tolerance to withstand high temperatures and thereby leads to an improved laser device lifetime.

The present disclosure also provides a system for heating a semiconductor structure surface for utilization in semiconductor manufacturing processes, and/or systems. The various embodiments and variants disclosed above apply *mutatis mutandis* to the present system without any limitations.

The system comprises an enclosure, and a pump configured to generate vacuum condition inside the enclosure. The *"pump"* as used herein refers to a vacuum pump configured to draw gas molecules from an enclosed space (such as, the enclosure) to create a partial vacuum i.e., to generate vacuum conditions inside the said enclosure. It will be appreciated that the pump comprises inherent piping system (i.e., network of connected pipes or tubes) interconnected with the enclosure to generate the vacuum conditions and wherein the pump utilized for generating the vacuum conditions may be selected based on the implementation to optimize the method without limiting the scope of the present disclosure. For example, the pump may be selected from at least one of, but not limited to, positive displacement pumps, regenerative pumps, entrapment pumps.

The system further comprises a laser heating source mounted in the enclosure. In particular, the system comprises a third port for mounting the laser heating source in the enclosure. The term *"port"* refers to an aperture or opening that extends through a wall of the enclosure, wherein the shape, size and curvature of the ports may be varied as per the requirements of the implementation. In an example, the port may be cylindrical port. It will be appreciated that the shape and size of the ports may be varied without limiting from the scope of the teachings herein. Herein, the laser heating source is configured to expose the first surface of the semiconductor structure to heat beam from the laser heating source, by disposing the first surface opposing the laser heating source. In one or more embodiments, the selection of the laser heating source is done based on the material of the semiconductor structure and the conditions thereat to perform the heating step effectively and efficiently. In the present embodiments, the laser heating source is configured to provide the directed heat beam by laser irradiation.

Optionally, the system further comprises a gate valve to control the conditions inside the enclosure and a controller configured to manipulate the fixture and control the movement and/or position of the fixture, by transmitting command signals to the fixture, for providing different positional configurations of the semiconductor structure for treatment within the enclosure. The *"gate valve"* refers to a type of valve (also known as a sluice valve), that opens by lifting a barrier out of a path. Beneficially, gate valves require very little space along transfer axis and hardly restrict the transfer when the gate is fully opened and thereby minimizes the physical footprint of the system. The term *"controller"* as used herein refers to a structure and/or module that includes programmable and/or non-programmable components configured to store, process and/or share information and/or signals for controlling the pump, gate valve, and/or the fixture. The said controller may be operatively coupled to the gate valve, and/or the fixture. Herein, the gate valve is configured to maintain the conditions of the enclosure, unless the controller transmits a command signal to open the gate valve for transfer of the semiconductor structure from the enclosure. In the present examples, the controller may include components such as memory, a controller, a network adapter, and the like, to store, process and/or share information with other components, such as a sensor, a remote server unit, a database, etc. Additionally, the system elements may communicate with each other using a communication interface.

### EXPERIMENT

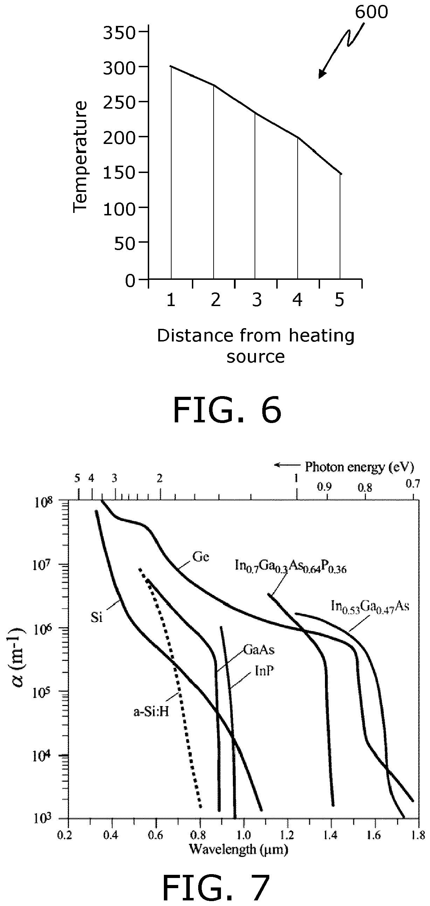

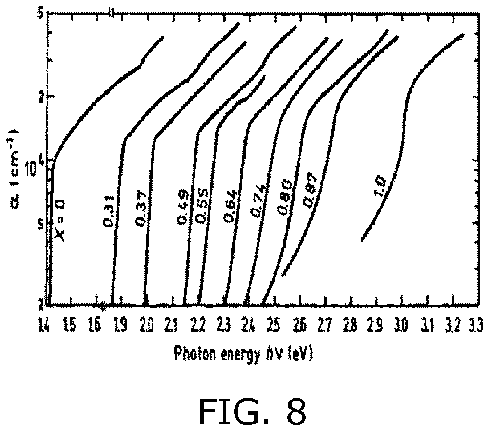

In FIG. 7, there is a graphical representation of the different absorption wavelengths of different semiconductors. In FIG. 8, there is a graphical representation of the different absorption wavelengths of AlGaAs with different aluminium content. Based on the available absorption data, it is estimated, when a 808 nm laser heating source is used, and the laser beam of the laser heating source is focused on the surface of the topmost layer of the stack of GaAs/Al(x)Ga(1-x)As/GaAs/Al(x)Ga(1-x)As/GaAs with x=4 (with 40% Al content) semiconductor structure, that GaAs is absorbing up to 900 nm of the heat radiation, and AlGaAs with 40% up to 700 nm of the heat radiation. Hence, when the laser heating method according to the present disclosure is used, this means that heat radiation will be absorbed by the GaAs, but it won't be absorbed by the AlGaAs of the semiconductor structure. Heat power densities used in this experiment were in the range of 0.2-20 W/cm², for example 1-10 W/cm².

### DETAILED DESCRIPTION OF THE DRAWINGS

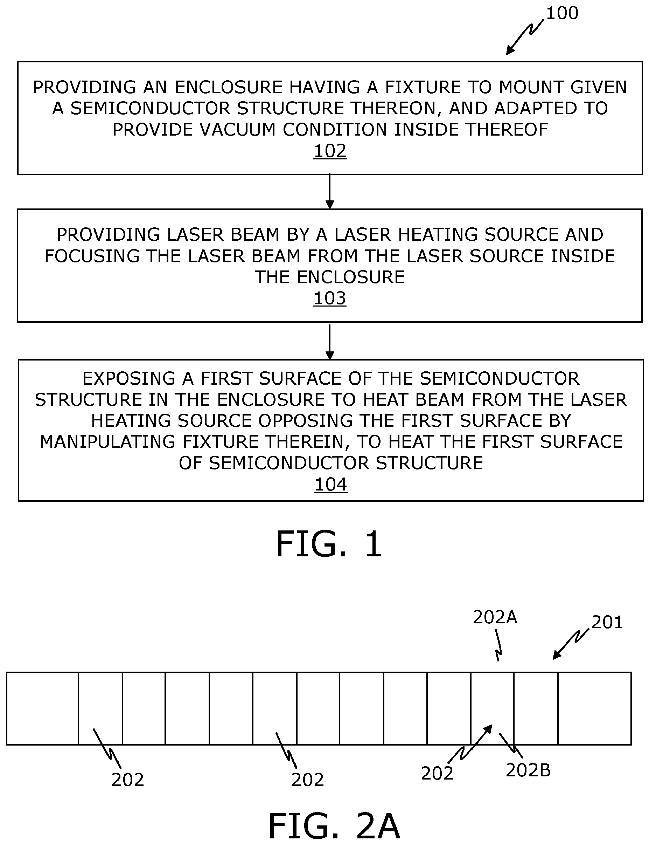

Referring to FIG. 1, illustrated is a flowchart illustrating steps involved in a method **100** of heating a semiconductor structure surface for utilization in semiconductor manufacturing processes, in accordance with an embodiment of the present disclosure. At a step **102,** the method **100** comprises providing an enclosure having a fixture to mount the given structure thereon in the enclosure and adapted to provide vacuum condition inside thereof. Herein, the vacuum conditions are provided (such as, via a pump) inside the enclosure to prevent external exposure to surroundings during processing and/or treatment of the semiconductor structure and prevent damage thereof (such as, due to COMD, corrosion). At a step **103,** the method **100** comprises providing laser beam by a laser heating source and focusing the heat beam from the laser source inside the enclosure. At a step **104,** the method **100** further comprises exposing the first surface of the semiconductor structure in the enclosure to heat beam from a laser heating source opposing the first facet by manipulating the fixture therein, to heat the first surface of the semiconductor structure surface for utilization in semiconductor manufacturing processes such as, passivation, deposition, and other treatment processes.

Referring to FIG. 2A, illustrated is a representative diagram of an exemplary semiconductor cleaved bar **201** comprising multiple semiconductor structures **202** therein, in accordance with an embodiment of the present disclosure. As shown, the semiconductor cleaved bar **201** comprises a plurality of cleaved semiconductor structures **202** arranged next to each other. Further, as shown, each cleaved semiconductor structure **202** has a first facet **202A** and a second facet **202B.** Herein, the semiconductor bar **201** is treated as per the method **100** (described above), wherein the cleaved semiconductor structures **202** are stacked to dispose the first facet **202A** and/or the second facet **202B** to described exposure processes to enable uniform treatment of the cleaved semiconductor structures **202.** Alternatively stated, the exposed first facet **202A** can be heated at all times i.e., before, during, or after cleaning step and/or oxidation step.

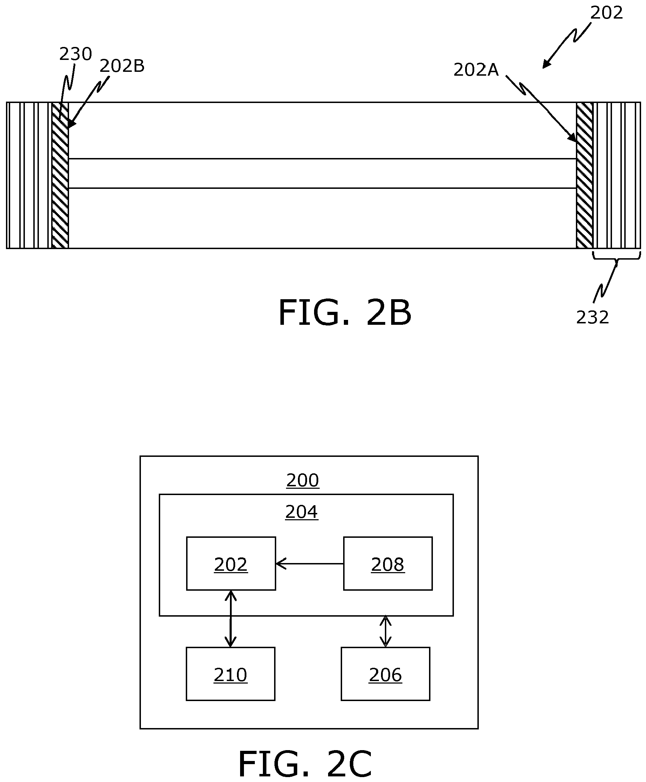

Referring to FIG. 2B, illustrated is a representative diagram of one of the exemplary cleaved semiconductor structures **202,** in accordance with an embodiment of the present disclosure. As shown, the cleaved semiconductor structure **202** provides the first facet **202A** and the second facet **202B** on opposing sides thereof. Further, the cleaved semiconductor structure **202** comprises a deposited passivating layer **230** (for example, group III atomic layer) deposited on each of the first and second facets **202A, 202B** for protection from potential damage from COMD, corrosion, and the like. Furthermore, the cleaved semiconductor structure **202** comprises deposited first layers **232** on each of the first and second facets **202A, 202B** for added protection from exposure to surroundings and thereby protecting the cleaved semiconductor structure **202** from damage effectively. For example, the deposited first layers **232** are metallic coatings. In another example, the deposited first layers **232** are mirror coatings.

Referring to FIG. 2C, illustrated is a block diagram of a system **200** for heating the cleaved semiconductor structure **202** (as shown in FIGs. 2A and 2B) for utilization in semiconductor manufacturing processes, in accordance with an embodiment of the present disclosure. As shown, the system **200** comprises an enclosure **204,** and a pump **206** configured to generate vacuum condition (e.g., to ultra-high vacuum (UHV) level) inside the enclosure **204.**The system **200** further comprises a laser heating source **208** mounted in the enclosure **204** to provide heat beam. The system **200** further comprises a fixture **210** adapted to mount the given structure **202** thereon in the enclosure **204,** wherein the fixture **210** is configured to be manipulated to expose the first facet **202A** (as shown in FIGs. 2A and 2B) and/or the second facet **202B** (as shown in FIGs. 2A and 2B) of the cleaved semiconductor structure **202** in the enclosure **204** to the heat beam from the laser heating source **208** by disposing the first facet **202A** opposing the laser heating source **208.** Herein, the heat beam may be provided by the laser heating source **208** either before or after the cleaning and/**or** oxidation process. Notably, the laser heating source **208** is a frontal irradiation source that is mounted externally to the enclosure **204.**

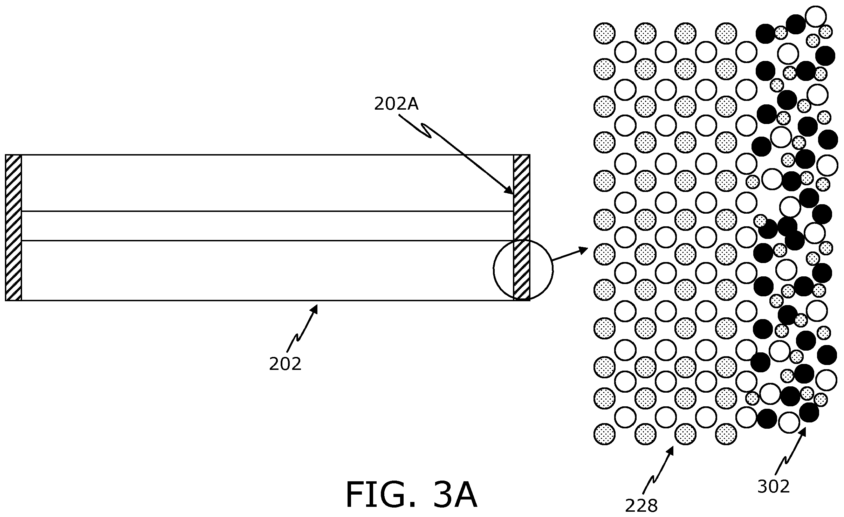

Referring to FIG. 3A, illustrated is a representative diagram of an exemplary cleaved semiconductor structure **202** before cleaning the first facet **202A** of the cleaved semiconductor structure **202.** As shown, the first facet **202A** comprises the crystalline layer **228** thereon, wherein the crystalline layer **228** is formed via group III to group V atoms. Further, the first facet **202A** has an amorphous oxide layer **302** contaminating the first facet **202A** of the cleaved semiconductor structure **202.** Thus, upon transferring the cleaved semiconductor structure **202** to the enclosure **208,** the first facet **202A** of the cleaved semiconductor structure **202** is exposed to the cleaning beam from the cleaning source **214** by manipulating the fixture **210** to remove the amorphous oxide layer **302** thereof. Beneficially, such a cleaning step removes the amorphous oxide layer **302** from the first facet **202A** of the cleaved semiconductor structure **202** prior to further treatment in an a quick, accurate and efficient manner.

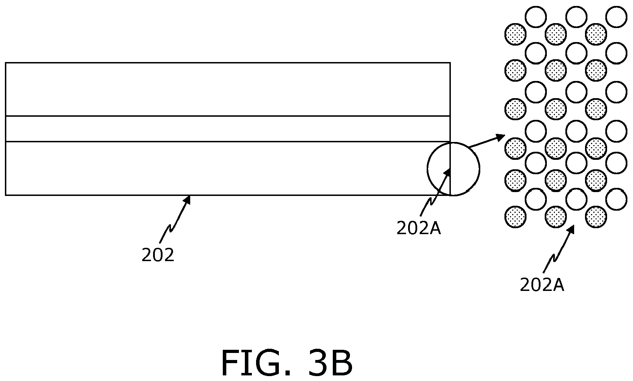

Referring to FIG. 3B, illustrated is a representative diagram of an exemplary cleaved semiconductor structure **202** after cleaning the first facet **202A** of the cleaved semiconductor structure **202.** As shown, upon cleaning the first facet **202A** of the cleaved semiconductor structure **202,** the amorphous oxide layer **302** is removed from the first facet **202A** of the cleaved semiconductor structure **202** and may thereafter be treated with other deposition or cleaning techniques as per requirement.

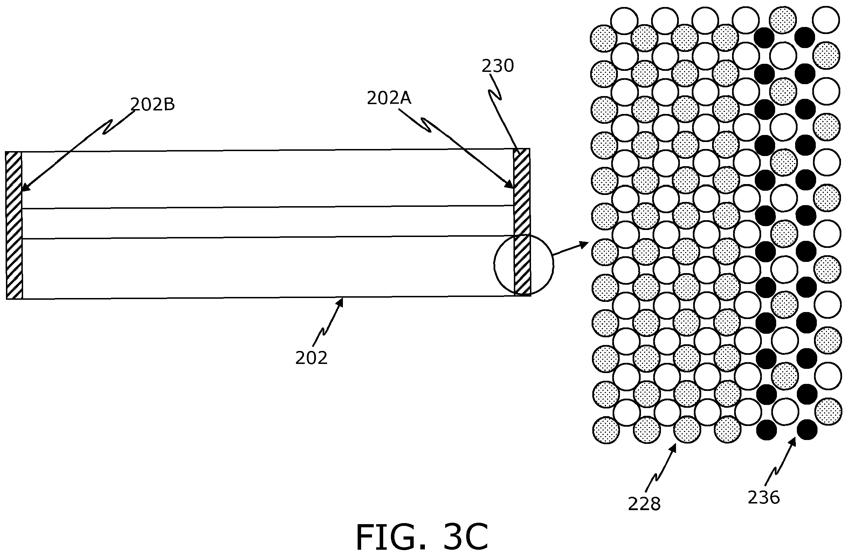

Referring to FIG. 3C, illustrated is a representative diagram of an exemplary cleaved semiconductor structure **202** after cleaning the first facet **202A** of the cleaved semiconductor structure **202** and provided with an ordered oxide layer **236** formed thereon. Herein, the oxidizing source **218** is configured to form the ordered oxide layer **236** via controlled oxidation onto the crystalline layer **228** formed on the first facet **202A,** wherein the fixture **210** is configured to be manipulated to expose the oxidation agent from the oxidizing source **218** to generate the ordered oxide layer **236.**

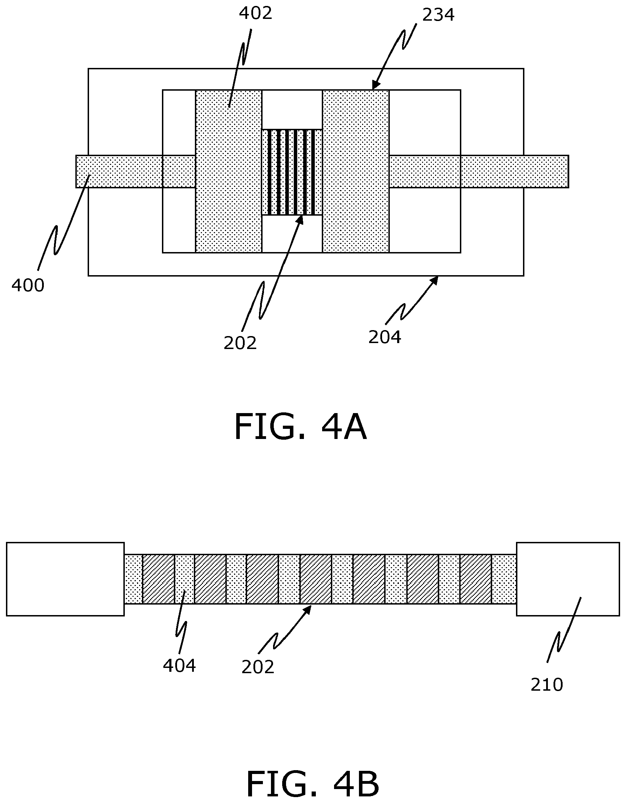

Referring to FIG. 4A, illustrated is a schematic diagram of an exemplary stacking fixture **234,** in accordance with one or more embodiments of the present disclosure. As shown, the stacking fixture **234** is configured for holding or stacking the plurality of cleaved semiconductor structures **202** therein. The stacking fixture **234** comprises either screws or springs **400** configured to push the clamps **402** against each other, adding a suitable pressure to keep the plurality of semiconductor structures **202** "sandwiched" between the clamps **402.** Referring to FIG. 4B, illustrated is a detailed view of the exemplary fixture **210** holding the plurality of cleaved semiconductor structures **202.** As shown, each of the plurality of cleaved semiconductor structures **202** is spaced apart by a spacing element **404** to isolate and protect the contacts of each of the cleaved semiconductor structures **202,** so that contacts of two adjacent cleaved semiconductor structures **202** are not touching each other directly, as they could melt, etc. The spacing element **404** may be GaAs, Sapphire, and the like.

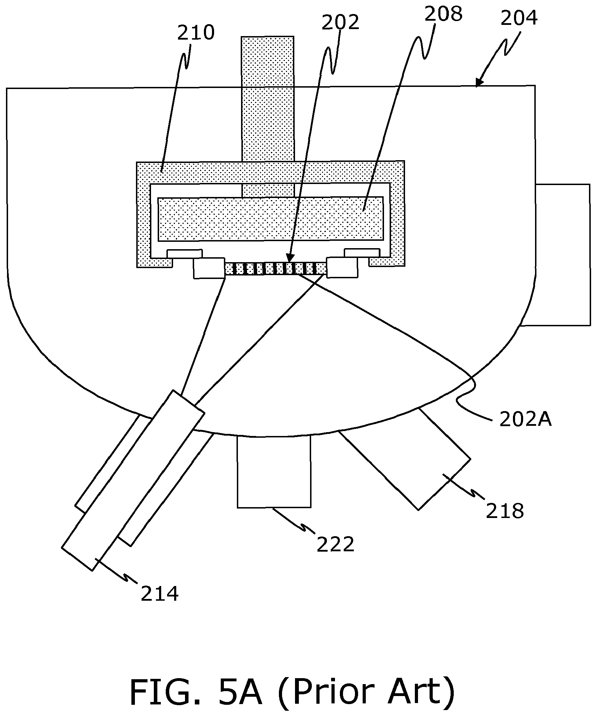

Referring to FIG. 5A, illustrated is a schematic diagram of a conventional heating method for heating the cleaved semiconductor structure **202.** As shown, the cleaved semiconductor bar **201** comprising the plurality of the cleaved semiconductor structures **202** are mounted onto the fixture **210** inside in the enclosure **204** for further treatment therein. Herein, the cleaning source **214,** the oxidizing source **218,** and the deposition source are configured to treat the first facet **202A** of the cleaved semiconductor structure from a first direction and the heating to be done by the conventional heating sources **208** was required to done from a direction opposite to the first direction i.e., opposite to the treated facet **202A** of the cleaved semiconductor structure **202** such as, in existing semiconductor manufacturing processes, such as passivation, deposition, etc. wherein the semiconductor structure **202** is required to be heated from a direction opposite to a treated facet **202A** of the cleaved semiconductor structure **202,** as shown in FIG. 5A and thereby requires higher amounts of heat energy to be applied which consequently causes damage to the surfaces of the semiconductor structure **202** and results in a poor efficiency for the system **200** or method **100.**

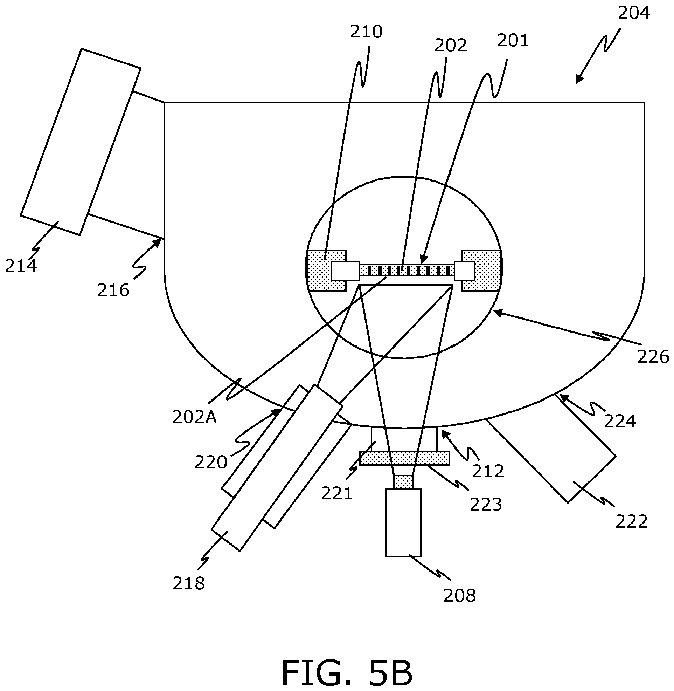

Referring to FIG. 5B, illustrated is a schematic diagram of a frontal heating-mechanism of the method **100** or system **200** for heating the cleaved semiconductor structure **202** surfaces to be utilized in semiconductor manufacturing processes, in accordance with one or more embodiments of the present disclosure. In light of the problems as shown in FIG. 5A, the method **100** or the system **200** of the present disclosure provides a novel frontal heating mechanism to overcome the aforementioned problems. As shown, the system **200** comprises the enclosure **204,** and the pump **206** (not shown) configured to generate vacuum condition (e.g., to ultra-high vacuum (UHV) level) inside the enclosure **204.**

Further shown in FIG. 5B, the system **200** further comprises a fixture **210** adapted to mount the given structure **202** thereon in the enclosure **204,** wherein the fixture **210** is configured to be manipulated to expose the first facet **202A** (as shown in FIGs. 2A and 2B) and/or the second facet **202B** (as shown in FIGs. 2A and 2B) of the cleaved semiconductor structure **202** in the enclosure **208** to the heat beam from the laser heating source **208** by disposing the first facet **202A** opposing the heating source **208.** Herein, the heat beam may be provided by the laser heating source **208** either before or after the cleaning and/or oxidation process. Notably, the laser heating source **208** is a frontal irradiation source that is mounted externally to the enclosure **204.** As shown, the cleaved semiconductor bar **201** comprising the plurality of the cleaved semiconductor structures **202** are mounted onto the fixture **210** inside in the enclosure **204** for further treatment therein. Herein, via manipulating the fixture **210,** the laser heating source **208** is exposed to a given facet (such as, the first facet **202A)** to heat the exposed facet **202A** of the cleaved semiconductor structure **202** to aid with the above-described process.

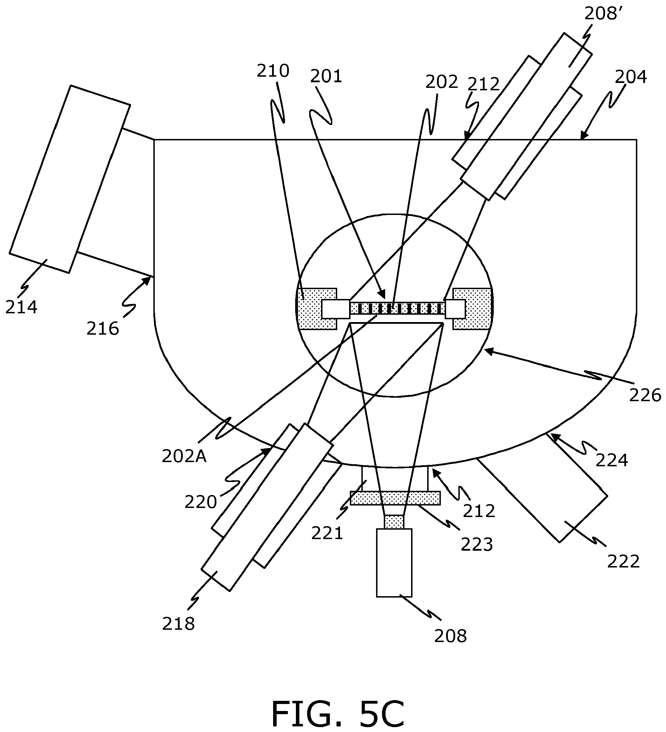

Further shown in FIG. 5B, the system **200** further comprises a heating source **208** mounted in the enclosure **204** to provide heat beam for heating the exposed facet **202A** of the cleaved semiconductor structure **202.** Particularly, the system **200** comprises a first port **212** configured for mounting the laser heating source **208** in the enclosure **204.** Herein, the laser heating source **208** may be employed either before or after, or during, the cleaning and/or oxidation process. As shown, the laser heating source **208** is a frontal irradiation source, such as a laser, that is mounted externally to the enclosure **204.** Therefore, the system **200** comprises a transparent viewport **221** (as shown in FIG. 5) to allow the heat beam from the laser heating source **222** to reach the cleaved semiconductor structure **202** in an efficient manner. Further, the system **200** comprises a beam shaper **223** (as shown in FIG. 5) to shape the heat beam from the heating source **222** to be directed (shaped accordingly) to the exposed facet of the cleaved semiconductor structure **202** mounted in the enclosure **204** (as discussed in detail in the proceeding paragraphs).

Further shown, in FIG. 5B, optionally, the system **200** further comprises a second port **216** for mounting a cleaning source **214** in the enclosure **204,** a third port **220** for mounting an oxidizing source **218** in the enclosure **204.** Further, as shown in FIG. 5C, the system **200** further comprises a fixture **210** adapted to mount the given structure **202** thereon in the enclosure **204,** wherein the fixture **210** is configured to be manipulated to expose the first facet **202A** (as shown in FIGs. 2A and 2B) and/or the second facet **202B** (as shown in FIGs. 2A and 2B) of the cleaved semiconductor structure **202** in the enclosure **204** to a cleaning beam from the cleaning source **214** by disposing the first facet **202A** opposing the cleaning source **214** and expose the first facet **202A** of the cleaved semiconductor structure **202** in the enclosure **204** to an oxidation agent from the oxidizing source **218** by disposing the first facet **202A** opposing the oxidizing source **218.**

Further shown, in FIG. 5B, optionally, the system **200** further comprises a deposition source **222** mounted in the enclosure **204.** In particular, as shown, the system **200** comprises a fourth port **224** for mounting the deposition source **222** in the enclosure **204.** Herein, the fixture **210** is configured to be manipulated to expose, prior to exposing the first facet **202A** to the oxidation agent from the oxidizing source **218,** the first facet **202A** of the cleaved semiconductor structure **202** in the enclosure **204** to group III atoms from the deposition source **222,** by disposing the first facet **202A** opposing the deposition source **222.** Optionally, the system **200** further comprises a monitoring equipment (not shown). The monitoring equipment is configured to be utilized to provide visibility for observation and/or monitoring of the surface of the cleaved semiconductor structure **202** in the enclosure **204.** For this purpose, as shown in FIG. 5, the system **200** further comprises a fifth port **226** in the form of a transparent viewport to allow the monitoring equipment, that is mounted externally, to be used to observe the cleaved semiconductor structure **202** inside the enclosure **204.**

Referring to FIG. 5C, illustrated is a schematic diagram of a dual heating-mechanism of the method **100** or system **200** for heating the cleaved semiconductor structure **202** surface to be utilized in semiconductor manufacturing processes, in accordance with one or more embodiments of the present disclosure. It will be appreciated that FIG. 5C is to be read in conjunction with FIG. 5A and 5B. Notably, herein, both facets **202A** and **202B** of the cleaved semiconductor structure **202** are treated simultaneously via the laser heating sources **208, 208'.** As shown, there are two laser heating sources **208** (a first laser heating source), **208'** (a second laser heating source) configured to heat both the facets **202A** and **202B** of the cleaved semiconductor simultaneously. Furthermore, there can be provided a beam shaper for each laser heating source. Beneficially, during operation, a single chamber i.e., the enclosure is utilized, wherein both facets i.e., the first facet and the second facet, may be heated and further treated, cleaned, and passivated without employing any other chambers or leaving the enclosure to make the method faster and efficient to solve the aforementioned problems of FIG. 5A and consequently increasing the efficiency and throughput of the method **100** or the system **200.** It will be appreciated that similarly two cleaning sources **214,** two oxidizing sources **218** and two deposition sources **222** may also be interchangeably utilized for an efficient semiconductor manufacturing process such as, passivation of the cleaved semiconductor structure **202.**

Referring to FIG. 6, illustrated is a graphical representation **600** of temperature variations inside the cleaved semiconductor structure **202** as a measure of distance from the exposed surface to the laser heating source, in accordance with an embodiment of the present disclosure. As shown, the x-axis and the y-axis depict the distance (in millimetres) from the exposed surface to the heating source and the temperature (in degree Celsius), respectively. Herein, it is observed that temperature follows an inverse relationship with distance, as the temperature decreases through the thickness of the semiconductor structure.

## Claims

1. A method (100) of heating a surface of a semiconductor structure for utilization in semiconductor manufacturing processes, the method comprising:
- providing an enclosure comprising a fixture to mount the given semiconductor structure thereon, which enclosure is adapted to provide vacuum condition inside thereof;
- providing heat beam by a laser heating source (208), and focusing the heat beam from the laser source (208) inside the enclosure, and
- exposing a first surface of the semiconductor structure in the enclosure to heat beam from the laser heating source opposing the first surface by manipulating the fixture therein, to heat the first surface of the semiconductor structure.

2. A method (100) according to claim 1 comprising
- providing heat beam by a second laser heating source (208') and focusing the heat beam from the second laser source (208') inside the enclosure, and
- exposing a second surface of the semiconductor structure opposite the first surface of the semiconductor structure in the enclosure to heat beam from the second laser heating source (208') opposing the second surface by manipulating the fixture therein, to heat the second surface of the semiconductor structure simultaneously with the first surface of the semiconductor structure.

3. A method (100) according to any of claims 1 or 2 further comprising
- providing a beam shaper for each of the laser heating sources (208, 208') to shape the heat beam from the each of the laser heating sources.

4. A method (100) according to any of claims 1 or 2 further comprising
- providing the heat beam from the laser heating source (208, 208') with selective wavelength(s) based on the surface of the semiconductor structure the heat beam is directed to.

5. A method (100) according to any of preceding claims, wherein the laser heating source (208, 208') is mounted externally to the enclosure, and wherein the method further comprises providing a transparent viewport to allow the heat beam from the laser heating source to reach the semiconductor structure.

6. A method (100) according to any of preceding claims, wherein the heat beam is provided by laser irradiation.

7. A method (100) according to any of preceding claims, wherein a plurality of semiconductor structures are loaded in the enclosure, being stacked on top of each other at respective side surfaces thereof, with the first surface being orthogonal to the corresponding side surface in the respective semiconductor structure, and wherein the method (100) further comprises manipulating the fixture in the enclosure to expose the first surface of each of the semiconductor structure of the plurality of semiconductor structures to the heat beam from the laser heating source (208, 208').

8. A method (100) according to any of preceding claims, wherein said manipulating comprises repositioning the fixture during heating the surface of the semiconductor structure.

9. A system (200) for heating a surface of a semiconductor structure (202) for utilization in semiconductor manufacturing processes, the system (200) comprising:
- an enclosure (204);
- a pump (206) configured to generate vacuum condition inside the enclosure (204);
- a laser heating source (208) to provide heat beam inside the enclosure;
- an optical device (223) configured to define the distribution or phase of the irradiated heat beam from the laser heating source, and
- a fixture (210) adapted to mount the given structure (202) thereon in the enclosure (204), wherein the fixture (210) is configured to be manipulated to expose the first surface (202A) of the semiconductor structure (202) to the heat beam from the laser heating source (208), by disposing the first surface (202A) opposing the laser heating source.

10. A system (200) according to claim 9 comprising a second laser heating source (208') to provide heat beam inside the enclosure.

11. A system (200) according to any of the claims 9-10 wherein the optical device (223) is a beam shaper configured to shape the heat beam from the laser heating source (208, 208') to be directed to the surface (202A, 202B) of the semiconductor structure (202).

12. A system (200) according to any of claims 9-11, wherein the laser heating source (208, 208') is mounted externally to the enclosure (204), and wherein the system (200) further comprises a transparent viewport (221) to allow the heat beam from the laser heating source (208, 208') to reach the semiconductor structure (202).

13. A system (200) according to any of claims 9-12, wherein the laser heating source (208, 208') is employed to provide the heat beam to the surface (202A, 202B) either before or after, or during, the cleaning and/or oxidation process of the surface (202A, 202B).

14. A system (200) according to any of claims 9-13, wherein the pulse width used in the laser heating source is in the range of 10-100µs, and the period width is in the range of 100-400µs.

15. A system (200) according to any of claims 9-14, wherein the heat power density used is in the range of 0.2-20 W/cm².
